Europäisches Patentamt

European Patent Office

Office européen des brevets

(11) Numéro de publication: **0 322 696 B1**

(12) **FASCICULE DE BREVET EUROPEEN**

(45) Date de publication de fascicule du brevet: **15.04.92**    (51) Int. Cl.5: **H01L 23/50**, H05K 1/11

(21) Numéro de dépôt: **88121210.4**

(22) Date de dépôt: **19.12.88**

(54) **Plot de report de connexion pour la fixation d'une broche à griffes sur la tranche d'un substrat de circuit hybride.**

(30) Priorité: **22.12.87 FR 8717919**

(43) Date de publication de la demande:
**05.07.89 Bulletin 89/27**

(45) Mention de la délivrance du brevet:
**15.04.92 Bulletin 92/16**

(84) Etats contractants désignés:
**BE DE FR GB IT NL SE**

(56) Documents cités:
**GB-A- 2 029 652**
**US-A- 3 689 684**

**32nd ELECTRONIC COMPONENTS CONFE-RENCE, 10-12 mai 1982, pages 346-353, IEEE, San Diego, California, US; H.N. KELLER: "Significant features of solder connections to gold-plated thin films"**

**SOLID-STATE TECHNOLOGY, vol. 25, no. 10, octobre 1982, pages 99-104, Port Washington, New York, US; E.A. GUTBIER et al.: "More reliable connections to condensation-soldered terminals"**

(73) Titulaire: **ALCATEL CIT**
**12 Rue de la Baume**
**F-75008 Paris(FR)**

(72) Inventeur: **Septfons, René**
**19 avenue du Bel Air**
**F-75012 Paris(FR)**
Inventeur: **Rabartin, Michel**
**128 avenue de l'Epi d'or**
**F-91400 Orsay(FR)**

(74) Mandataire: **Weinmiller, Jürgen et al**
**Lennéstrasse 9 Postfach 24**
**W-8133 Feldafing(DE)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services

# Description

La présente invention concerne les circuits hybrides c'est-à-dire des sous-ensembles de composants électroniques assemblés sous une forte densité sur un support plat dit substrat qui est en général une mince plaquette de céramique recouverte sur une ou deux faces d'un réseau sérigraphié de résistances et de pistes conductrices protégées ou non par un revêtement isolant vitrifié et de plots étamables pour la fixation des composants électroniques par brasure. Elle est relative plus particulièrement aux plots étamables dits de report de connexion qui sont disposés le long des bords des substrats et servent à la fixation de broches utilisées pour les raccordements électriques des circuits hybrides avec l'environnement extérieur.

D'une façon générale les broches de connexion réalisées en bande par estampage et pliage dans une tôle conductrice comportent une tête se terminant par une pince élastique à trois griffes déportée sur un côté et destinée à s'accrocher sur la tranche d'un substrat, deux griffes venant d'un côté du substrat et la troisième de l'autre.

Les plots de report de connexion de bord de substrat destinés a recevoir ces broches sont constitués habituellement, de deux plages étamables rectangulaires de la largeur de la pince des broches, placées en vis à vis sur les côtés opposés d'un bord du substrat, aux endroits de préhension des trois griffes de la pince d'une broche.

Le montage des bandes de broches de connexion sur les bords du substrat se fait alors que ce dernier, encore à l'état nu, a été étamé en vue d'un report global des composants et de leur brasage simultané par refusion, et que les plots de report de connexion sont recouverts de dômes de brasure d'une épaisseur difficilement contrôlable, non négligeable par rapport à celle du substrat. Il en résulte au moins deux inconvénients, le premier étant la difficulté de centrage de la pince à trois griffes d'une broche sur un plot en raison de son relief en double dôme rappelant la forme d'une sphère et le deuxième étant que l'épaisseur des dômes de brasure d'un plot dépasse parfois les limites d'élasticité de la pince à griffes des broches et provoque alors une diminution de l'effet ressort qui ne permet plus aux griffes de la pince de revenir au contact du substrat pendant l'opération de refusion.

La présente invention a pour but de lutter contre ces inconvénients qui allongent le temps de montage et conduisent à un taux de retouche élevé.

Elle a pour objet un plot de report de connexion pour la fixation d'une broche à griffes sur la tranche d'un substrat de circuit hybride comportant au moins une plage étamable qui est placée sur un bord du substrat, aux endroits de préhension des griffes de la broche formant les mâchoires d'une pince élastique pour enserrer la tranche du substrat et y fixer la broche, tel que connu de US-A-3 689 684 ou SOLID STATE TECHNOLOGY, Vol.25, No.10, octobre 1982, pages 99-104 et qui est caractérisé en ce que la plage étamable est découpée, pour chaque griffe de la broche venant du côté du substrat où cette plage est disposée, d'une rainure à l'emplacement du chemin de coulissement suivi par la griffe considérée de la broche lors de sa mise en place sur la tranche du substrat, rainure qui a une largeur un peu inférieure à celle de la griffe afin que cette dernière morde sur la plage étamable.

Avantageusement, le plot de report de connexion comporte deux plages étamables placées en vis-à-vis sur les côtés opposés d'un bord de substrat. Dans le cas d'une broche ayant une pince élastique à trois griffes disposées côte à côte, la griffe médiane venant d'un premier côté du substrat et les deux griffes extérieures du deuxième côté du substrat, la plage étamable du plot de report de connexion placée sur le deuxième côté du substrat a de préférence la forme d'un T, les rainures aux emplacements des chemins de coulissement des deux griffes extérieures délimitant le jambage du T et butant contre ses épaulements tandis que la plage étamable du plot de report de connexion placée sur le premier côté du substrat a de préférence la forme d'un U, la rainure à l'emplacement du chemin de coulissement de la griffe médiane pénétrant entre les ailes du U et butant au fond de celui-ci.

Les rainures aux emplacements des chemins de coulissement des griffes de la pince d'une broche forment des vallées dans les dômes de brasure recouvrant les plages étamables de plots de report qui permettent d'une part de centrer sans difficulté la pince d'une broche sur le plot et d'autre part, de présenter à cette pince une épaisseur assez peu différente de celle du substrat qui reste dans tous les cas dans ses limites d'élasticité.

La refusion avec une recharge simultanée ou ultérieure par immersion ou mouillage dans un bain de brasure des plots et des griffes des broches qui y sont fixées provoque l'application par effet de ressort des griffes des broches sur la tranche du substrat et par conséquent l'immobilisation des broches sur le substrat jusqu'à solidification de la brasure, la migration sur les griffes de la brasure chargeant les plages étamables puis le recouvrement des griffes et des plages étamables par des dômes de brasure.

D'autres caractéristiques et avantages de l'invention ressortiront de la description ci-après d'un mode de réalisation donné à titre d'exemple. Cette description sera faite en regard du dessin qui comporte :

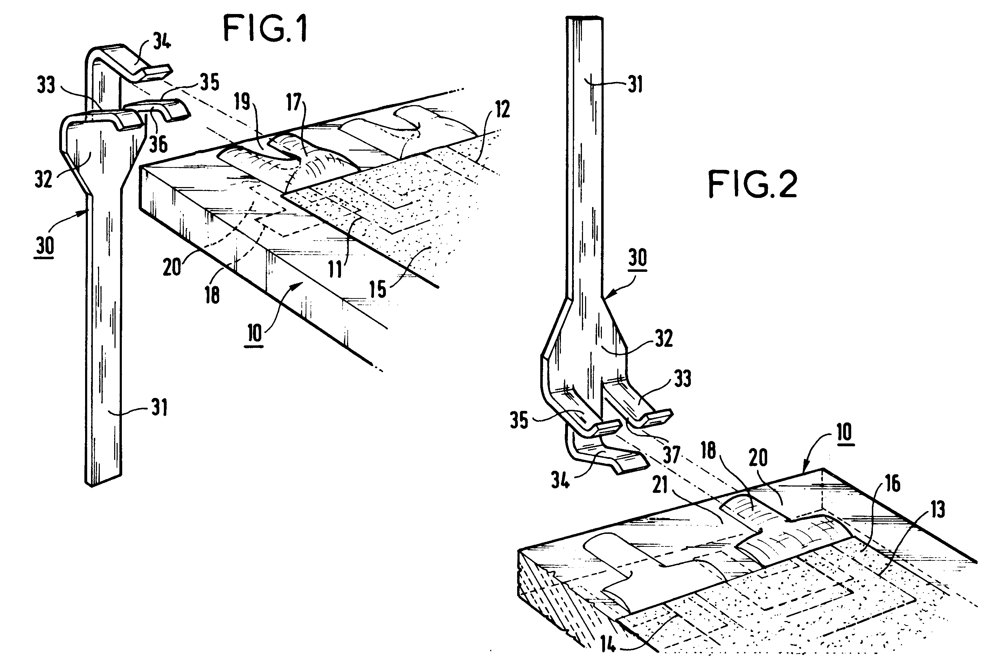

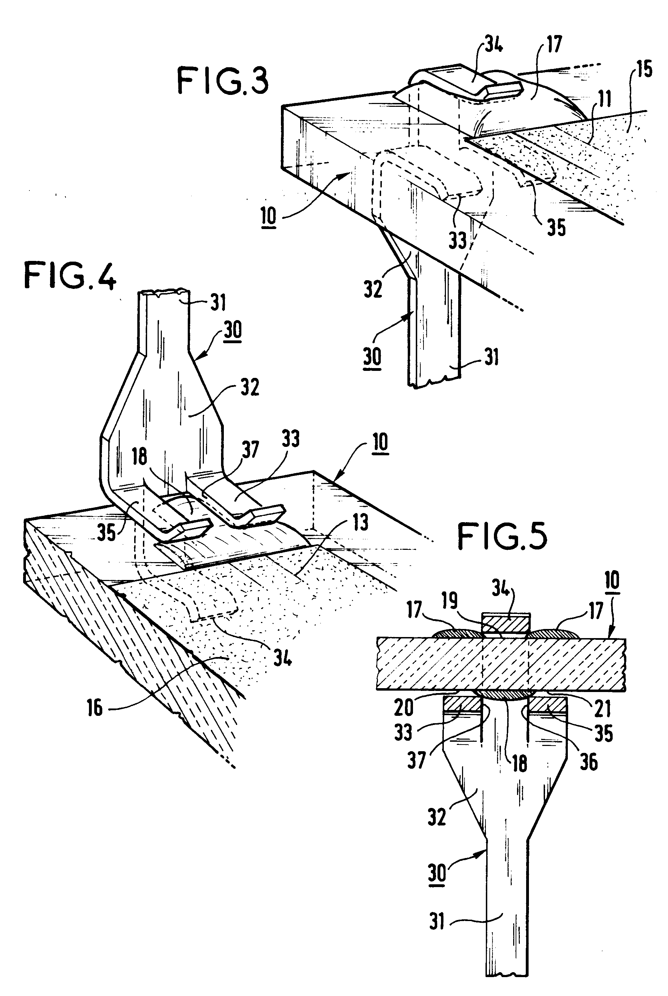

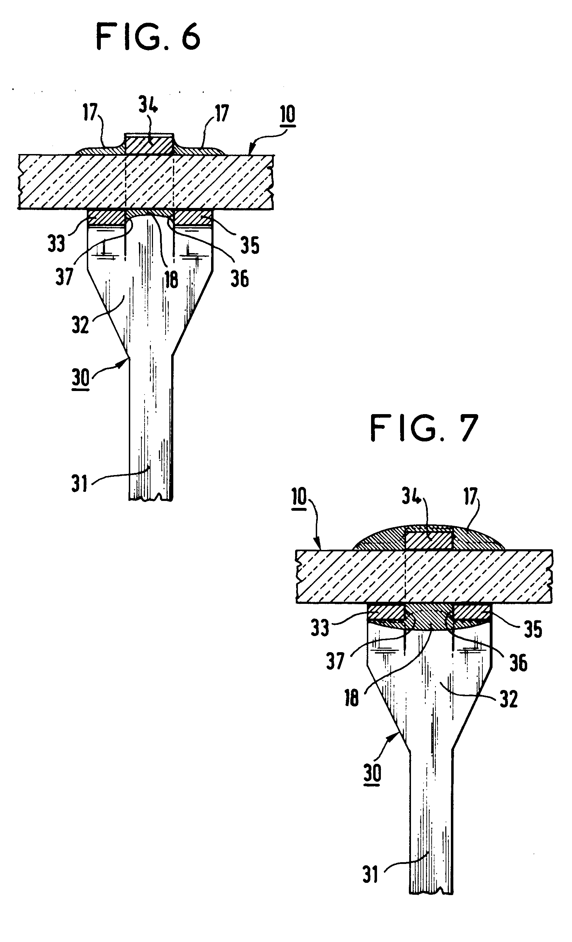

- des figures 1 et 2 montrant, en perspective vue du dessus et du dessous, une broche présentée face à un plot de report de connexion de bord conforme à l'invention destiné à la recevoir;
- des figures 3 et 4 montrant, en perspective vue du dessus et du dessous, une tête de broche en place sur un plot de report de connexion de bord conforme à l'invention et;
- des figures 5, 6 et 7 montrant en coupe l'accrochage des griffes d'une tête de broche sur un plot de report de connexion de bord conforme à l'invention avant et après un brasage par refusion sans ou avec recharge de brasure.

On distingue sur les figures 1 et 2 un coin de substrat 10 de circuit hybride supportant deux plots de report de connexion de bord et, en vis à vis, une broche de connexion 30 destinée à être mise en place sur l'un des plots de report.

Le substrat 10 de circuit hybride est constitué d'une mince plaquette de céramique de l'ordre de 0,6 mm d'épaisseur portant sur chacune de ses faces un réseau de pistes conductrices 11, 12, 13, 14 sérigraphié qui est recouvert d'une couche de protection isolante vitrifiée 15, 16 et mène à des plages étamables de plots de connexion de composant et de plots de report de connexion de bord. Les plots de report de connexion de bord comportent chacun deux plages étamables 17, 18 placées en vis à vis de part et d'autre d'un bord de la tranche du substrat 10. Ces plages étamables 17, 18, comme celles des plots de connexion des composants supportent des dômes de brasure résultant d'un étamage, à l'état nu du sustrat 10, en vuedu brasage, en une seule opération de refusion, de toutes les connexions après mise en place des composants sur le substrat 10.

La broche de connexion 30 réalisée par estampage et pliage d'une tôle conductrice présente une queue de connexion 31 pourvue d'une tête élargie de fixation 32 prolongée de trois griffes 33, 34, 35 disposées côte à côte et rabattues d'un même côté selon un pliage approprié pour former une pince élastique à ouverture latérale et mâchoires évasées adaptée à l'épaisseur du substrat 10.

Les deux griffes extérieures 33, 35 rabattues à leur naissance selon un même profil constituent la mâchoire inférieure de la pince tandis que la griffe médiane rabattue seulement à mi-longueur surplombe les deux autres et constitue la mâchoire supérieure de la pince.

Les plages étamées 17, 18 d'un plot de report de connexion qui viennent entre les griffes 33, 34, 35 de la pince d'une broche de connexion 30 sont entaillées de rainures 19, 20, 21 qui sont perpendiculaires au bord du substrat et débouchent sur ce dernier. D'une largeur un peu inférieure à celle des griffes 33, 34, 35, elles suivent les chemins de coulissement de celles-ci lors de la mise en place d'une broche de connexion 30 sur le plot de report de connexion.

Dans le cas représenté d'un espacement réduit entre les broches (1/10ème de pouce ou 2,54 mm) les plages étamables 17, 18 d'un plot de report de connexion ne dépassent pas la largeur totale des trois griffes 33, 34, 35 d'une broche de connexion de sorte que celle 17 où vient prendre appui la seule griffe médiane 34 se trouve entaillée d'une rainure médiane 19 lui donnant la forme générale d'un U et que celle 18 où viennent prendre appui les deux griffes extérieures 33, 35 se trouve encochée de part et d'autre par deux rainures 20 et 21 lui donnant la forme générale d'un T.

Dans le cas d'un espacement moins réduit, les plages étamables d'un plot de report de connexion peuvent dépasser la largeur des trois griffes 33, 34, 35 d'une broche de connexion, celle 17 où vient en appui la seule griffe médiane 34 conservant la forme d'un U mais avec des ailes plus larges et celle 18 où viennent en appui les deux griffes extérieures 33, 35 prenant la forme d'un W.

Plusieurs plots de report de connexion voisins peuvent aussi être réunis pour mettre plusieurs broches en parallèle et permettre par exemple le passage d'une intensité de courant plus importante. Leurs plages étamables en vis à vis de part et d'autre d'un bord du substrat 10 forment alors des barrettes qui longent ce bord et sont entaillées de rainures perpendiculaires espacées conformément à l'écartement des empreintes des griffes 33, 34, 35 des broches venant s'y fixer.

Les rainures 19, 20, 21 aux emplacements des chemins de coulissement des griffes 33, 34, 35 de la pince d'une broche 30 forment des vallées entre ou sur les bords des dômes de brasure recouvrant les plages étamables 17, 18 d'un plot de report de connexion dans lesquelles s'encastrent les griffes 33, 34, 35. Cela assure d'une part un centrage automatique de la pince de la broche 30 sur le plot de report et d'autre part diminue l'amplitude de l'ouverture de cette pince en lui évitant d'avoir à absorber toute l'épaisseur des dômes de brasure recouvrant les plages étamables 17, 18.

Comme représenté sur les figures 3, 4 et 5, les griffes 33, 34, 35 de la pince d'une broche de connexion 30 une fois en place sur un plot de report de connexion mordent sur les bords des plages étamables 17, 18 de ce plot, la griffe médiane 34 par son extrémité et chacun de ses bords latéraux et les griffes extérieures 33, 35 par leurs extrémités et leurs bords latéraux en regard 36, 37. Cela est obtenu, en donnant à la rainure médiane 19 constituant l'ouverture de la forme en U de la plage étamable 17 une largeur inférieure, par exemple de 0,02 à 0,25 mm, à celle de la griffe médiane 34 et à l'écartement entre les rainures 20, 21 déterminant la largeur du jambage de la forme en T de la plage étamable 18 une largeur supérieure, par exemple de 0,1 à 0,5 mm, à l'espacement des deux griffes extérieures 33, 35. Dans l'exemple représenté, la largeur de l'ouverture de la forme en U de la plage étamable 17 est de 0,5 mm pour une largeur de la griffe médiane de 0,55 mm et la largeur du jambage de la forme en T de la plage étamable 18 de 0,8 mm pour un écartement entre les griffes extérieures 33, 35 de 0,55 mm.

Grâce au léger chevauchement maintenu entre les griffes 33, 34, 35 d'une broche de connexion 30 et les plages étamables 17, 18 du plot de report de connexion, la brasure contenue dans les dômes peut facilement migrer sur les griffes 33, 34, 35 lors d'une opération de refusion. La figure 6 montre le résultat obtenu après une opération de refusion, sans recharge de brasure, la brasure présente dans les dômes des plages étamables 17, 18 ayant rejoint, par capillarité, les bords et les extrémités des griffes 33, 34, 35 de la broche 30. La figure 7 montre le résultat obtenu après une opération de refusion et une recharge de brasure simultanée ou ultérieure par immersion ou mouillage dans un bain de brasure du ou des bords du substrat 10 portant des plots de report de connexion équipés de broches, la brasure du bain ainsi que celle déposée initialement sur les plages étamables 17, 18 ayant formé de nouveaux dômes recouvrant complétement les griffes 33, 34, 35 de la broche 30.

## Revendications

1. Plot de report de connexion pour la fixation d'une broche à griffes sur la tranche d'un substrat (10) de circuit hybride comportant au moins une plage étamable (17, 18) placée sur un bord du substrat(10), aux endroits de préhension des griffes (33, 34, 35) de la broche (30) qui forment les mâchoires d'une pince élastique pour enserrer la tranche du substrat (10) et y fixer la broche (30), caractérisé en ce que ladite plage étamable (17, 18) est entaillée, pour chaque griffe de la broche venant du côté du substrat où cette plage est disposée, d'une rainure (19, 20, 21) à l'emplacement du chemin de coulissement suivi par la griffe considérée (33, 34, 35) de la broche (30) lors de sa mise en place sur la tranche du substrat (10), ladite rainure (19, 20, 21) ayant une largeur un peu inférieure à celle de la griffe (33, 34, 35) afin que cette dernière morde sur la plage étamable (17, 18).

2. Plot selon la revendication 1, pour la fixation d'une broche (30) à trois griffes (33, 34, 35) disposées côte à côte, la griffe médiane (34) venant d'un premier côté du substrat (10) et les deux griffes extérieures (33, 35) du deuxième côté, ayant deux plages étamables (17, 18) placées en vis-à-vis sur les côtés opposés du substrat ne dépassant pas la largeur totale des trois griffes (33, 34, 35), caractérisé en ce que sa plage étamable (17) placée sur le premier côté du substrat (10) se trouve entaillée d'une rainure (19) lui donnant la forme générale d'un U dont les ailes encadrent la griffe médiane (34) de la broche (30) et en ce que sa plage étamable (18) placée sur le deuxième côté du substrat (10) se trouve encochée de part et d'autre par des rainures (20, 21) lui donnant la forme générale d'un T dont le jambage se place entre les griffes extérieures (33, 35) de la broche (30).

3. Plot selon la revendication 1, pour la fixation d'une broche (30) à trois griffes (33, 34, 35) disposées côte à côte, la griffe médiane (34) venant d'un premier côté du substrat (10) et les deux griffes extérieures (33, 35) du deuxième côté, ayant deux plages étamables (17, 18) placées en vis-à-vis sur les côtés opposés du substrat plus larges que les trois griffes (33, 34, 35) réunies, caractérisé en ce que sa plage étamable (17) placée sur le premier côté du substrat (10) se trouve entaillée d'une rainure (19) lui donnant la forme générale d'un U dont les ailes encadrent la griffe médiane (34) de la broche (30) et en ce que sa plage étamable (18) placée sur le deuxième côté du substrat (10) se trouve entaillée de deux rainures lui donnant la forme générale d'un W dont les ailes encadrent les griffes extérieures (33, 35) de la broche (30).

4. Plot selon la revendication 2, ou la revendication 3, caractérisé en ce que sa plage étamable (17) en forme de U à une ouverture centrale de largeur inférieure de 0,02 à 0,25 mm par rapport à la largeur de la griffe médiane (34) de la broche (30).

5. Plot selon la revendication 2, caractérisé en ce que sa plage étamable (18) en forme de T a une largueur au niveau du jambage du T supérieure de 0,1 à 0,5 mm à l'espacement des deux griffes extérieures (33, 35) de la broche (30).

## Claims

1. A terminal connection pad for fixing a clawed terminal fork on the wafer of a hybrid circuit substrate (10), including at least one tinnable area (17, 18) placed on the margin of the substrate (10) in the grasp positions of the claws (33, 34, 35) of the terminal fork (30), which claws constitute the jaws of a resilient clamp for pinching the wafer of the substrate (10) and for fixing the terminal fork (30) thereto, characterized in that said tinnable area (17, 18) is notched, for each of the claws of the fork engaging said side of the substrate on which the area is disposed, with a groove (19, 20, 21) in the slide path followed by the corresponding claw (33, 34, 35) of the terminal fork (30) when the latter is being placed on the wafer of the substrate (10), said groove (19, 20, 21) having a width which is slightly narrower than the width of the claw (33, 34, 35), so that the claw cuts into the tinnable area (17, 18).

2. A terminal pad according to claim 1, for fixing a terminal fork (30) having three claws (33, 34, 35) disposed side by side, the central claw (34) engaging a first side of the substrate (10) and two outer claws (33, 35) engaging the second side, the pad having two tinnable areas (17, 18) placed face to face on opposite sides of the substrate, which do not exceed the total width of the three claws (33, 34, 35), characterized in that the tinnable area (17) placed on the first side of the substrate (10) is notched by a groove (19), thus assuming the general shape of a U whose legs surround the central claw (34) of the terminal fork (30), and in that its tinnable area (18) placed on the second side of the substrate (10) is notched on either side by grooves (20, 21) which confer to the area the general shape of a T, whose leg mates the place situated between the outer claws (33, 35) of the terminal fork (30).

3. A terminal pad according to claim 1, for fixing a terminal fork (30) having three claws (33, 34, 35) disposed side by side, with the central claw (34) engaging a first side of the substrate (10) and two outer claws (33, 35) engaging the second side, the pad having two tinnable areas (17, 18) which are placed face to face on opposite sides of the substrate and which are larger than the assembly of the three claws (33, 34, 35), characterized in that the tinnable area (17) placed on the first side of the substrate (10) is notched by a groove (19), thus assuming the general shape of a U whose legs surround the central claw (34) of the terminal fork (30), and in that its tinnable area (18) placed on the second side of the substrate (10) is notched on either side by grooves (20, 21) which confer to the area the general shape of a W, whose legs surround the outer claws (33, 35) of the terminal fork (30).

4. A terminal pad according to claim 2 or 3, characterized in that the U-shaped tinnable area (17) has a central opening whose width is 0.02 mm to 0.25 mm smaller than the width of the central claw (34) of the terminal fork (30).

5. A terminal pad according to claim 2, characterized in that the T-shaped tinnable area (18) has a width at the leg of the T which is 0.1 mm to 0.5 mm larger than the gap between the two outer claws (33, 35) of the terminal fork (30).

**Patentansprüche**

1. Anschluß-Lötkuppe zur Befestigung einer Gabelklemme auf der Schnittkante eines Hybridschaltungssubstrats (10), mit mindestens einem verzinnbaren Bereich (17, 18), der auf dem Rand des Substrats (10) an den Griffpunkten der Gabelfinger (33, 34, 35) der Gabelklemme (30) angeordnet ist, die die Backen einer elastischen Zange zum Einklemmen der Schnittkante des Substrats (10) und zum Befestigen der Gabelklemme (30) bilden, dadurch gekennzeichnet, daß der verzinnbare Bereich (17, 18) bei jedem Finger, der auf die Seite des Substrats kommt, auf der der Bereich angeordnet ist, mit einer Rinne (19, 20, 21) eingekerbt ist, die sich an der Stelle des von dem betreffenden Finger (33, 34, 35) der Gabelklemme (30) bei seinem Aufstecken auf der Schnittkante des Substrats (10) verfolgten Gleitweg befindet, wobei die Rinne (19, 20, 21) eine Breite besitzt, die etwas kleiner als diejenige des Fingers (33, 34, 35) ist, damit letzterer sich in den verzinnbaren Bereich eingräbt.

2. Lötkuppe nach Anspruch 1 zur Befestigung einer Gabelklemme (30) mit drei nebeneinander angeordneten Fingern (33, 34, 35), von denen der mittlere Finger (34) auf eine erste Seite des Substrats (10) und die beiden äußeren Finger (33, 35) auf die andere Seite gelangen, wobei die Lötkuppe zwei verzinnbare Bereiche (17, 18) aufweist, die auf den entgegengesetzten Seiten des Substrats einander gegenüberliegend angeordnet sind und die Gesamtbreite der drei Finger (33, 34, 35) nicht überschreiten, dadurch gekennzeichnet, daß der verzinnbare Bereich (17) auf der ersten Seite des Substrats (10) mit einer Kerbe (19) versehen ist, die ihm die allgemeine Form eines U verleiht, dessen Schenkel den mittleren Finger (34) der Gabel-klemme (30) einrahmen, und daß der auf der zweiten Seite des Substrats (10) gelegene verzinnbare Bereich (18) an beiden Seiten mit Kerben (20, 21) versehen ist, die ihm die allgemeine Form eines T verleihen, dessen Bein sich zwischen die äußeren Gabelfinger (33, 35) der Gabelklemme (30) legt.

3. Lötkuppe nach Anspruch 1 zur Befestigung einer Gabelklemme (30) mit drei nebeneinander angeordneten Fingern (33, 34, 35), von denen der mittlere Finger (34) auf eine erste Seite des Substrats (10) und die beiden äußeren Finger (33, 35) auf die andere Seite gelangen, wobei die Lötkuppe zwei verzinnbare Bereiche (17, 18) aufweist, die auf den entgegengesetzten Seiten des Substrats einander gegenüberliegend angeordnet sind und breiter als die Gesamtheit der drei Finger (33, 34, 35) sind, dadurch gekennzeichnet, daß ihr verzinnbarer Bereich (17) auf der ersten Seite des Substrats (10) mit einer Kerbe (19) versehen ist, die ihm die allgemeine Form eines U verleiht, dessen Schenkel den mittleren Finger (34) der Gabelklemme (30) einrahmen, und daß ihr auf der anderen Seite des Substrats (10) gelegener verzinnbare Bereich (18) an beiden Seiten mit Kerben (20, 21) versehen ist, die ihm die allgemeine Form eines W verleihen, dessen Flügel die äußeren Gabelfinger (33, 35) der Gabelklemme (30) einrahmen.

4. Lötkuppe nach Anspruch 2 oder 3, dadurch gekennzeichnet, daß ihr verzinnbarer U-förmiger Bereich (17) eine zentrale Öffnung mit einer um 0,02 bis 0,25 mm kleineren Breite als die Breite des mittleren Fingers der Gabelklemme (30) aufweist.

5. Lötkuppe nach Anspruch 2, dadurch gekennzeichnet, daß ihr verzinnbarer T-förmiger Bereich (18) in Höhe des Beines des T eine um 0,1 bis 0,5 mm größere Breite als der Abstand der beiden äußeren Finger (33, 35) der Gabelklemme (30) besitzt.

FIG.1

FIG.2

EP 0 322 696 B1

FIG.3

FIG.4

FIG.5

8

# FIG. 6

# FIG. 7